Europäisches Patentamt

European Patent Office

Office européen des brevets

(11) Veröffentlichungsnummer: **0 417 335 A1**

(12) **EUROPÄISCHE PATENTANMELDUNG**

(21) Anmeldenummer: 89116800.7

(22) Anmeldetag: 11.09.89

(51) Int. Cl.5: **H03K 19/094**

(43) Veröffentlichungstag der Anmeldung:
20.03.91 Patentblatt 91/12

(84) Benannte Vertragsstaaten:
**DE FR GB IT NL SE**

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) Schaltungsanordnung zur Wandlung von Signalen mit TTL-Pegel in Signale mit CML-Pegel oder ECL-Pegel.

(57) Schaltungsanordnung mit einem ersten (T1) und zweiten (T2) Bipolartransistor, deren gekoppelte Emitteranschlüsse über eine erste Stromeinprägung (S1) an ein erstes Potential (V1) und deren Ausgangssignale führende Kollektoranschlüsse jeweils direkt oder über einen Widerstand (R1, R2) an ein zweites Potential (V2) angeschlossen sind, durch einen an dem Gateanschluß mit einem ersten Eingangssignal (E1) beaufschlagten ersten Feldeffekttransistor (Q1), dessen Drainanschluß über einen dritten Widerstand (R3) mit dem zweiten Potential (V2) und dessen Sourceanschluß zum einen mit der Basis des ersten Bipolartransistors (T1) und zum anderen über eine zweite Stromeinprägung (S2) mit dem ersten Potential (V1) verbunden ist, und durch einen an dem Gatenanschluß mit einem zweiten Eingangssignal (E2) beaufschlagten zweiten Feldeffektransistor (Q2), dessen Drainanschluß über einen vierten Widerstand (R4) mit dem zweiten Potential (V2) und dessen Sourceanschluß zum einen mit der Basis des zweiten Bipolartransistors (T2) und zum anderen über eine dritte Stromeinprägung (S3) mit dem ersten Potential (V1) verbunden ist.

## SCHALTUNGSANORDNUNG ZUR WANDLUNG VON SIGNALEN MIT TTL-PEGEL IN SIGNALE MIT CML-PEGEL ODER ECL-PEGEL

Die Erfindung betrifft eine Schaltungsanordnung zur Wandlung von Signalen mit TTL-Pegel in Signale mit CML-Pegel oder ECL-Pegel.

In zahlreichen Anwendungsfällen ist es notwendig, Signale von Schaltungen in Transistor-Transistor-Logic (TTL) Schaltungen in Current-Mode-Logic (CML) bzw. Schaltungen in Emitter-Coupled-Logic (ECL) zuzuführen. Dies ist jedoch nicht möglich ohne weiteres, da die Signalpegel der einzelnen Schaltungstypen unterschiedlich sind. Die größten Unterschiede ergeben sich dabei zwischen dem TTL-Pegel und dem CML- bzw. ECL-Pegel, während sich CML- und ECL-Pegel einander mehr entsprechen. Dies läßt sich anhand der für den jeweiligen logischen Zustand geforderten Spannungsbereiche leicht verdeutlichen. Dem Zustand L entspricht bei TTL eine Spannung zwischen -1,2 Volt und +0,8 Volt, bei CML eine Spannung von ungefähr -0,5 Volt und bei ECL eine Spannung von ungefähr -1,3 Volt. Dem Zustand H ist bei TTL eine Spannung zwischen +2,0 Volt und +5,5 Volt, bei CML eine Spannung von ungefähr gleich 0 Volt und bei ECL eine Spannung von ungefähr -0,8 Volt gleichzusetzen. Es werden deshalb spezielle Schaltungsanordnungen benötigt, die die sehr unterschiedlichen Pegel einander anpassen.

Aus Texas Instruments, The Integrated Circuit Catalogue for Design Engineers, First Edition 1972, S. 4-74 und 4-83, ist eine Schaltungsanordnung zur Wandlung von Signalen mit TTL-Pegel in Signale mit ECL-Pegel bekannt. Der schaltungstechnische Aufwand und damit verbunden die Leistungsaufnahme dieser Anordnung ist jedoch relativ hoch.

Aufgabe der Erfindung ist es daher, eine Schaltungsanordnung zur Wandlung von Signalen mit TTL-Pegel in Signale mit ECL-Pegel bzw. CML-Pegel mit geringerem schaltungstechnischen Aufwand anzugeben.

Die Aufgabe wird bei einer Schaltungsanordnung der eingangs genannten Art durch die kennzeichnenden Merkmale des Patentanspruches 1 gelöst. Eine Ausgestaltung des Erfindungsgedankens ist in einem Unteranspruch gekennzeichnet.

Vorteile der Erfindung sind die steile Transferkurve im Eingangs-Pegel-Bereich, die kurzen Laufzeiten bei kleiner verlustleistung, und die Vermeidung von Sättigung der Transistoren im gesamten Eingangs-Pegel-Bereich.

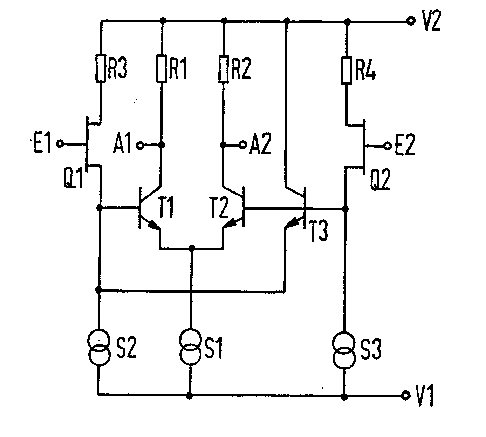

Die Erfindung wird nachfolgend anhand des in der einzigen FIG der Zeichnung dargestellten Ausführungsbeispiels näher erläutert.

Das Ausführungsbeispiel zeigt ein Transistorpaar mit einem ersten und zweiten Bipolartransistor T1, T2 vom npn-Typ, deren gekoppelte Emitteranschlüsse über eine erste Stromeinprägung S1 an ein negatives erstes Potential V1 und deren Kollektoranschlüsse jeweils über einen Widerstand R1, R2 an ein positives zweites Potential V2 angeschlossen sind, wobei die Widerstände R1, R2 gegebenenfalls auch durch Leitungsbrücken ersetzt werden können. An den Kollektoranschlüssen von erstem und zweitem Bipolartransistor T1, T2 werden darüber hinaus auch Ausgangssignale A1, A2 abgenommen. Die Basis des ersten Bipolartransistor T1 ist zum einen über eine zweite Stromeinprägung S2 mit dem ersten Potential V1 und zum anderen mit dem Sourceanschluß eines ersten MOS-Feldeffekttransistors Q1 vom n-Kanal-Typ verbunden. Der erste Feldeffekttransistor Q1 ist seinerseits am Gateanschluß mit einem ersten Eingangssignal E1 und am Drainanschluß über einen dritten Widerstand R3 mit dem zweiten Potential V2 beaufschlagt. In gleicher Weise ist die Basis des zweiten Bipolartransistors T2 zum einen über eine dritte Stromeinprägung S3 mit dem ersten Potential V1 und zum anderen mit dem Sourceanschluß eines zweiten MOS-Feldeffekttransistors Q2 vom n-Kanal-Typ verbunden. An den Gateanschluß des zweiten Feldeffekttransistors Q2 ist ein Referenzpotential E2 und an dessen Drainanschluß über einen vierten Widerstand R4 das zweite Potential V2 gelegt.

In Ausgestaltung der Erfindung ist ein dritter Bipolartransistor T3 vom npn-Typ vorgesehen, dessen Basis mit der Basis des zweiten Bipolartransistors T2 und dessen Emitter mit der Basis des ersten Bipolartransistors T1 verschaltet ist. Der Kollektor des dritten Bipolartransistors T3 ist mit dem zweiten Potential V2 beaufschlagt. Vorteil dabei ist eine geringere Abhängigkeit von der Dimensionierung der übrigen Elemente.

Weitere Ausführungsformen der erfindungsgemäßen Schaltungsanordnung ergeben sich beispielsweise durch Ausbildung der Ersatz der Stromeinprägungen S1-S3 teilweise oder gänzlich als bipolare Stromquellen, als Stromquellen in MOS-Technik oder als ohmsche Widerstände, wobei bei den beiden zuletzt genannten der dritte Bipolartransistor T3 prinzipiell entfallen kann. Darüber hinaus sind auch Dimensionierungen möglich, bei denen auf den dritten und vierten Widerstand R3, R4 verzichtet werden kann. Im übrigen erfolgt die Anpassung des Ausgangspegels an ECL-Pegel bzw. an CML-Pegel über die Dimensionierung der einzelnen Bauelemente.

**Ansprüche**

1. Schaltungsanordnung **gekennzeichnet durch** einen ersten und zweiten Bipolartransistor (T1, T2), deren gekoppelte Emitteranschlüsse über eine erste Stromeinprägung (S1) an ein erstes Potential (V1) und deren Ausgangssignale (A1, A2) führende Kollektoranschlüsse jeweils direkt oder über einen Widerstand (R1, R2) an ein zweites Potential (V2) angeschlossen sind, durch einen an dem Gateanschluß mit einem ersten Eingangssignal (E1) beaufschlagten ersten Feldeffekttransistor (Q1), dessen Drainanschluß über einen dritten Widerstand (R3) mit dem zweiten Potential (V2) und dessen Sourceanschluß zum einen mit der Basis des ersten Bipolartransistors (T1) und zum anderen über eine zweite Stromeinprägung (S2) mit dem ersten Potential (V1) verbunden ist, und durch einen an dem Gateanschluß mit einem Referenzpotenial (E2) beaufschlagten zweiten Feldeffekttransistor (Q2), dessen Drainanschluß über einen vierten Widerstand (R4) mit dem zweiten Potential (V2) und dessen Sourceanschluß zum einen mit der Basis des zweiten Bipolartransistors (E2) und zum anderen über eine dritte Stromeinprägung (S3) mit dem ersten Potential (V1) verbunden ist.

2. Schaltungsanordnung nach Anspruch 1, **gekennzeichnet durch** einen kollektorseitig an dem zweiten Potential (V2) angeschlossen dritten Bipolartransistor (T3), dessen Basis mit der Basis des zweiten Bipolartransistors (T2) und dessen Emitter mit der Basis des ersten Bipolartransistors (T1) verschaltet ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 645 951 (URAGAMI)<br>* Figur 9; Spalte 9, Zeile 56 - Seite 10, Zeile 39 *<br>--- | 1 | H 03 K 19/094 |
| A | US-A-4 453 095 (WRATHALL)<br>* Figur 2B; Seite 4, Zeile 59 - Seite 5, Zeile 33 *<br>--- | 1 | |
| A | EP-A-0 232 969 (TOSHIBA)<br>* Figur 1; Seite 4, Zeile 11 - Seite 10, Zeile 4 *<br>--- | 1 | |
| A | EP-A-0 132 148 (TEXAS INSTRUMENTS)<br>--- | 1 | |
| A | EP-A-0 200 230 (NEC CORP.)<br>--- | 1 | |
| A | IBM TECHNICAL DISCLOSURE BULLETIN, Band 21, Nr. 7, Dezember 1978, Seiten 2874-2875, New York, US; R. CLEMEN et al.: "Vt-compensated TTL-compatible MOS amplifier"<br>--- | 1 | |
| A | EP-A-0 326 947 (SIEMENS)<br>----- | 1,2 | **RECHERCHIERTE SACHGEBIETE (Int. Cl.5)**<br><br>H 03 K |

Der vorliegende Recherchenbericht wurde für alle Patentansprüche erstellt

| Recherchenort | Abschlußdatum der Recherche | Prüfer |
|---|---|---|
| DEN HAAG | 16-05-1990 | FEUER F.S. |